(19) Europäisches Patentamt
European Patent Office
Office européen des brevets

(11) **EP 0 754 782 B1**

(12) **EUROPEAN PATENT SPECIFICATION**

(45) Date of publication and mention
of the grant of the patent:
**20.02.2002 Bulletin 2002/08**

(51) Int Cl.7: **C30B 25/00**

(21) Application number: **96850130.4**

(22) Date of filing: **04.07.1996**

(54) **Manufacture of titanium carbide, nitride and carbonitride whiskers**

Herstellung von Titankarbid-, Titannitrid- und Titankarbonitridwhiskern

Fabrication de whiskers en carbure, nitrure et carbonitrure de titane

(84) Designated Contracting States:
**AT CH DE FR GB IT LI SE**

(30) Priority: **20.07.1995 US 504779**
**22.12.1995 SE 9504625**

(43) Date of publication of application:
**22.01.1997 Bulletin 1997/04**

(73) Proprietor: **SANDVIK AKTIEBOLAG**
**811 81 Sandviken (SE)**

(72) Inventors:
• **Nygren, Mats**
**161 42 Bromma (SE)**
• **Johnsson, Mats**
**126 53 Hägersten (SE)**
• **Ahlen, Niklas**
**146 45 Tullinge (SE)**
• **Ekelund, Magnus**
**153 91 Järna (SE)**

(74) Representative: **Taquist, Lennart et al**
**Sandvik AB Patent Department**
**811 81 SANDVIKEN (SE)**

(56) References cited:
**DE-A- 4 138 002          US-A- 4 756 791**
**US-A- 4 888 084**

• **PATENT ABSTRACTS OF JAPAN vol. 012, no. 143 (C-492), 30 April 1988 & JP-A-62 260797 (KOBE STEEL LTD;OTHERS: 01), 13 November 1987,**
• **PATENT ABSTRACTS OF JAPAN vol. 010, no. 172 (C-354), 18 June 1986 & JP-A-61 022000 (KANEBO KK;OTHERS: 01), 30 January 1986,**

Remarks:
The file contains technical information submitted after the application was filed and not included in this specification

**Description**

The present invention relates to a method of producing, in large volumes and at low cost, titanium carbide, nitride or carbonitride whiskers generally submicron in diameter (having excellent reinforcing properties) suitable as reinforcement material in ceramic cutting tools but also in other materials, including metals, intermetallics, plastics and metallic bonded hard material.

During the last decades great progress has been made in the development of high-performance materials. One of the important reasons to this progress has been the production of inorganic (ceramic) whiskers which have high tensile strength and modulus values as well as resistance to high temperatures. The incorporation of these whiskers into advanced ceramics, metals, and polymers has produced composites with superior properties.

Ceramic fibres can be produced by several methods and are most often in the form of single-crystals or so called "whiskers". Several types of ceramic whiskers (oxides, nitrides, carbides and borides) exist. For example, SiC-whiskers are well-known as a successful reinforcement in cutting tool materials. Most of the development work has hence been directed toward silicon carbide whiskers (e.g. $Al_2O_3$-matrix/SiC-whiskers composites). Some efforts have, however, also been made to develop other metal carbide-, nitride-, and boride-whiskers particularly of transition metals such as Ti, Ta, and Nb. Mostly whiskers with diameters equal to or exceeding 1-2 micrometers are obtained. Transition metal ceramic whiskers with submicron diameter are, however, not readily available which, so far, has made most of these whisker materials less interesting as reinforcement in different types of advanced ceramic materials.

Ceramic whiskers available commercially are in most cases very expensive and in the case of most transition metal whiskers, no commercial producer exists.

U.S. pat. 3,754,076 discloses a method of producing silicon carbide whiskers by carbothermal reduction of rice hulls. Rice hulls contain both silica and a significant excess of carbon. When using rice hulls as a raw material the rice hulls and silica therefore are intimately mixed. By heating the raw material, the cellulose give off gaseous products such as carbon dioxide, carbon monoxide, hydrogen, methane and water vapour. The product contains besides SiC whiskers and particles, a large amount of excess carbon which has to be removed.

In U.S. pat. 4,248,844, SiC whiskers is produced in a similar process as in U.S. pat. 3,754,076. A part of the rice hulls are, however, ashed in air to remove the carbon and then remixed with a carbonised fraction of rice hulls.

In U.S. patent 4,283,375 rice hulls are ashed in air to obtain amorphous $SiO_2$ which is blended with fine particle sized carbon. This process is claimed to give β-SiC whiskers with a good yield.

U.S. patent 4,284,612 describes a process of preparing SiC whiskers by using chopped carbon fibres made from partly oxidised organic fibres. The fibres should be approximately 10 to 100μm in length. The patent does, however, not give any explanation way the graphite fibers give a better whisker yield.

U.S. patent 5,221,526 uses silica and a particulate carbon source together with a boron component and a seeding component to control the shape and size of the produced SiC-whiskers.

The carbothermal process of producing SiC-whiskers has the general potential to produce large amounts to a low cost if the reaction condition can be properly controlled.

U.S. patent 4,888,084 discloses a method for the preparation of titanium nitride whiskers by carbothermal reaction of mixtures of $TiO_2$, carbonised organic fibres and a catalyst such as Ni or Co. During the process a halogen, preferably a chlorine-containing gas is passed over the mixture. It is thought that the carbon fibres performs three functions: i) provide a high void volume necessary for the whisker growth, ii) act as a reducing agent for the titanium oxide, iii) act as a nucleation site for the whisker growth.

In U.S. patent 5,256,243, a process of making TiC whiskers from a mixture of $TiO_2$ or alkali metal compounds thereof, alkali metal chlorides and carbon by carbothermal reduction is described.

U.S. patent 4,883,559 discloses a process for making transition metal whiskers from melt of cyanide salt, alkali metal oxides and a transition metal oxide.

U.S. patent 5,094,711 discloses a process for producing single crystal titanium carbide whiskers by Chemical Vapour Deposition (CVD).

U.S. patent 5,160,574 discloses a process for production of small diameter titanium carbide whiskers by a CVD method.

In the case of transition metal carbide, nitride or carbonitride whiskers the carbothermal process has not been as successful as in the case of silicon carbide whisker synthesis. The CVD process works with a well controlled composition of the gas phase, but the cost is high and the possibility of producing large amount of whiskers with submicron diameters is low.

It is an object of this invention to provide a method of producing, in large volumes and at low cost, high strength whiskers of titanium carbide, nitride or carbonitride, to be used as reinforcing materials in advanced materials, which: (i) are straight; (ii) have smooth surfaces; (iii) have a diameter in the micron range, preferably being submicron.

These and other objects are provided by a method of producing titanium-carbide, -nitride, or -carbonitride whiskers in large volumes and in high yields comprising:

Intimate mixture of: (i) a carbon powder containing a volatile part which volatilises at a temperature above 500°C; (ii) a titanium compound (oxide, hydroxide and/or alkali oxide) in an amount to satisfy the stoichiometric requirements of the desired whisker; (iii) a halogenide source, in a Ti:halogenide molar ratio of 1:0.05-3; (iv) and a metal catalyst, in a Ti:catalyst molar ratio of 1:0.01-0.5, which at the reaction temperature is able to dissolve Ti, C, and N, preferably Ni or Co or an alloy thereof or any Ni- or Co- compound, preferably $NiCl_2$, which will decompose to the metal and a volatant component at the reaction temperature. HCl and $Cl_2$ can also be used as halogenide source.

Heating the mixture to 1000-1800°C for 0.5-18 hours, at 0.5 - 5 bar pressure in a non-oxidative atmosphere (such as Ar, $N_2$, $H_2$, He). The reaction temperature and reaction time is influenced by the particle size of the titanium oxide source.

The whisker growth in the invention is a VLS-like crystal growth process (VLS = Vapour-Liquid-Solid). This process implies transport of Ti as a vapour species to a liquid catalyst at which the desired whisker is grown as a solid. The halogenide source is added as a volatilising agent for transportation of titanium in a gas phase e.g. as a chloride or oxochloride. One of several possible reaction sequences when $Cl_2(g)$ is used as chlorine source is:

$$TiO_2(s) + (2-y)C(s) + (X/2)Cl_2(g) \rightarrow TiO_yCl_x(g) + (2-y)CO(g)$$

The formation of a volatile Ti-species provides for a gas phase transportation of Ti to the liquid metal catalyst where it reacts further with C and/or N to form a whisker of the composition $TiC_{1-X}N_X$ with $0 \leq X \leq 1$. The obtained X-value depends on the composition of the starting mixture, reaction temperature and atmosphere used. The overall reaction for synthesis of whiskers within the solid solution series $0 \leq X \leq 1$ may be written:

$$TiO_2(s) + (3-X)C(s) + (X/2)N_2(g) \rightarrow TiC_{1-X}N_X(s) + 2CO(g)$$

The VLS growth process involves several reactions which one by one and/or in combination have to be optimised in order to obtain maximum yield of whiskers.

Figure 1 shows the weight loss versus temperature curve in argon atmosphere for a carbon source with volatile components (○) according to the invention and for a carbon powder without volatile components (□).

Figure 2 shows in 1700X and figure 3 shows in 800X SEM micrographs of TiC and TiN whiskers respectively, synthesised according to the presently claimed invention.

According to the presently claimed invention, it is possible to synthesize submicron diameter whiskers of titanium carbide, nitride or carbonitride from starting mixtures of titanium oxides, hydroxides or alkali oxides thereof and carbon powder containing a volatile part and an alkali and/or alkali earth metalhalogenide using a catalyst. The obtained whiskers are of superior quality, useful as reinforcement in different types of materials e.g. plastics, metals, intermetallics, metallic bonded hard materials and ceramics.

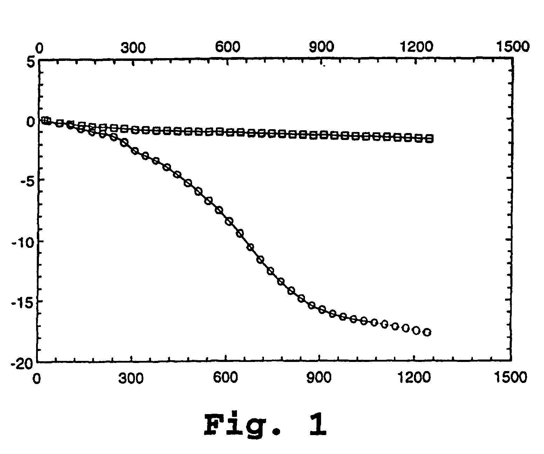

According to the presently claimed invention, it has been found that by using a carbon powder, with a primary grain size (that is, a majority of the powder) of 10-50nm eg = 15nm containing a volatile part in amounts between 10 wt% and 30 wt%, which part volatilizes at temperatures exceeding 500°C, the porosity of the starting mixture is kept at a high level through the whole reaction. This facilitates the growth of whiskers within the volume of the starting mixture and provides the whisker with an accurate mixture of gas species that are generated from the starting mixture. The porosity also makes it easy for nitrogen gas to penetrate the reaction mixture in case of synthesizing a nitride or carbonitride whisker. Carbon powder with such a volatile portion is commercially available, i.e. from Degussa AG. The carbon source is an oxidized carbon black that has oxygen-containing functional groups such as carboxyl and chinon on the surface of the powder which are the volatile portion and which volatilise at temperatures above 500°C (see figure 1). It may also contain some hydrocarbons. Such a carbon powder is easily produced in large amounts and is commercially available on the market, i.e. Degussa Color Black FW200 or FW2, Degussa Special Black 6, 5 or 4. The porosity of the reaction mixture can easily be controlled by varying the type and amount of volatile component to a greater extent compared to when chopped carbon fibers is used as described in earlier patents.

The reaction mixture contains titanium oxide or alkali oxide compound thereof with grain sizes typically between 1 and 50μm and with preferably a fluffy appearance, and the above-mentioned carbon powder, in amounts to satisfy the stoichiometric requirements of the desired compound to be produced (e.g. carbide or nitride). A halogenide containing salt like NaF, KF, LiF, LiCl, NaCl, KCl, $MgCl_2$ or $CaCl_2$, alone or in combination, in a Ti:halogenide molar ratio of 1:(0.05-3) is added as a volatilization agent for titanium. A chlorine-containing gas may also be added to the synthesis atmosphere as a volatilising agent, alone or in combination with a halogenidesalt. A metal catalyst for the whisker growth that is able to dissolve Ti plus C and/or N, e.g. Ni and/or Co powder of conventional grain size, or a Ni- or Co-compound, that will decompose to the metal and a volatile component at the reaction temperature, is added in a Ti:catalyst molar ratio of 1:(0.01-0.5).

The reactant powder are mixed, wet or dry, in some conventional manner, e.g. by using a high speed blender so as to intimately mix them. The bulk density of the reaction mixture should be low so that the surfaces of the powders are accessible to reaction gases and so that the reaction products can be removed. The desired bulk density for a particular mixture can be readily obtained by the skilled artisan.

The reactant mixture is heated in a furnace at 1000 - 1800°C, in a non-oxidative atmosphere, with a low gas flow (=40ml/min). The reaction temperature ranges from 1000 to 1800°C and the reaction time from 0.5 to 18 hours, and the pressure in the reaction zone from 0.5 to 5 bar. The reaction takes place in a reaction chamber made of some inert material, such as alumina, zirconia or graphite or a combination of them, preferably graphite. Different designs can be used but all allowing a gas exchange between the reactor chamber and the surrounding atmosphere.

The carbon:titanium molar ratio to be used depends on the selected titanium source and the desired product (nitride, carbide or carbonitride). Also, depending on the type of titanium source and on the type of whiskers to be produced, different synthesis parameters such as temperature and gas phase composition must be chosen.

$N_2$-gas is utilized as the nitrogen source for the production of nitrogen containing whiskers according to the presently claimed invention. A single titanium source or a combination of different titanium sources is mixed with the carbon powder. The overall chemical reaction for formation of TiN from e.g. $TiO_2$ can be written:

$$TiO_2(s) + 2C(s) + 1/2N_2(g) \rightarrow TiN(s) + 2CO(g)$$

It is essential for this reaction to proceed to the right, that the CO(g)-partial-pressure is held sufficiently low and that nitrogen gas is provided to the interior of the reaction mixture. This means that the nitrogen gas must penetrate the mixture whose porosity is held at highest possible level using the carbon powder according to the presently claimed invention.

In this way, high quality whiskers of nitride with low levels of residual free oxygen are obtained.

The overall chemical reaction for formation of TiC from e.g. $TiO_2$ can be written:

$$TiO_2(s) + 3C(s) \rightarrow TiC(s) + 2CO(g)$$

The temperature is preferably held between 1200 and 1600°C in an argon atmosphere for three hours. Argon gas is preferred instead of nitrogen gas since the titanium nitride is thermodynamically stable compared to titanium carbide at the reaction temperature.

By choosing an intermediate amount of carbon, a nitrogen atmosphere and a temperature in the same range as for the carbide synthesis, carbonitride whiskers are obtained.

The result of the synthesis according to the presently claimed invention, is a mixture of generally submicron diameter whiskers in an amount of 70 to 90% by volume. In addition submicron particles of the same compound is formed. This high yield makes an extra separation of whiskers and particles unnecessary. However, if an even higher yield is desired, a subsequent refinement step can be applied.

The preparation conditions given above, both with regard to the starting formulation and to the synthesis parameters, are related to the equipment used, design of the reaction chamber, the choice of raw materials etc. It is within the purview of the skilled artisan using other equipment and other raw materials to determine the optimal conditions by experiments.

Example 1

$TiO_2$ rutile powder (Tioxide sandy rutile) was mixed with carbon powder (Degussa FW200), NaCl (Merck) and Ni powder (Cerac 325 mesh) with mole fractions $TiO_2$ : C = 1 : 3, $TiO_2$ : NaCl = 1 : 0.5, and $TiO_2$ : Ni = 1 : 0.05. The carbon source contained 21 wt% volatile components which was compensated for.

The powders were mixed in ethanol and allowed for mixing on a rolling bench for 24 hours and then dried and subjected to carbothermal reduction with the following process parameters:

T=1500°C
t=3 hours
Protecting atmosphere: Ar(g)
p(Ar)=1bar

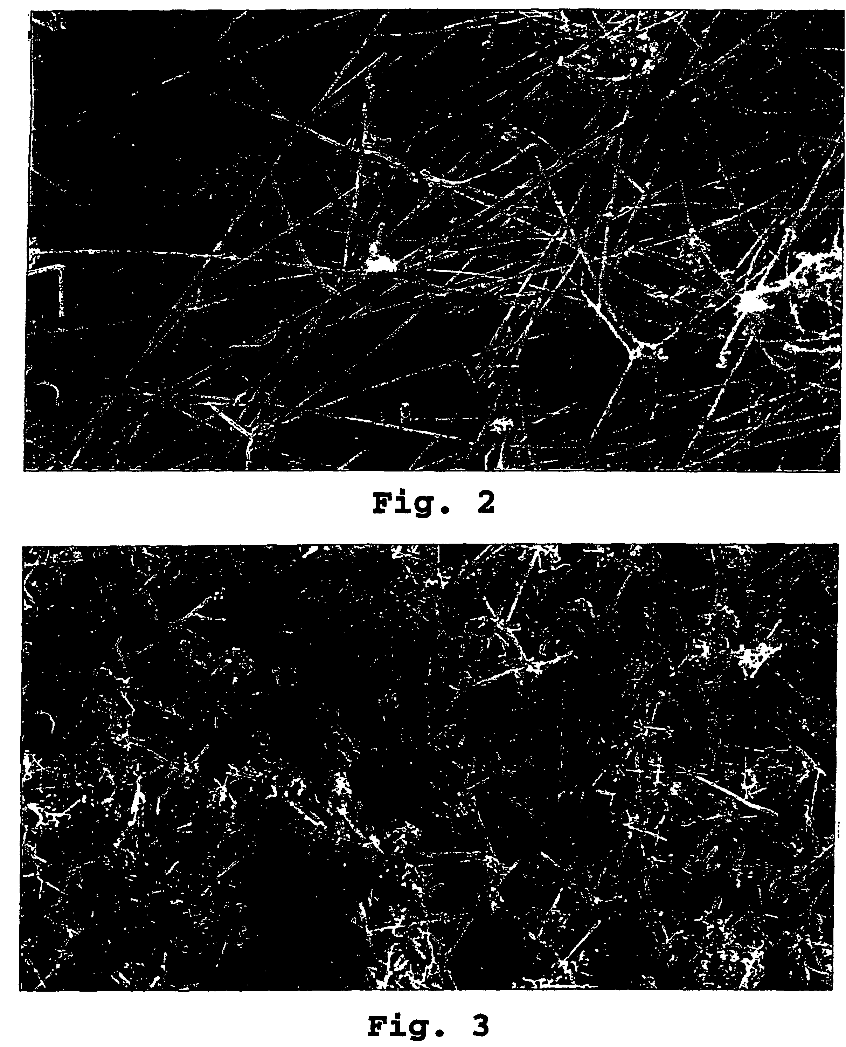

The whiskers produced consisted of TiC with a lattice parameter of a=4.3151(3)Å. The whisker yield was approximately 80% by volume. The whiskers were straight and of submicron size (see figure 2).

Example 2

TiO$_2$ rutile powder (Tioxide sandy rutile) was mixed with carbon powder (Degussa FW200), CaCl$_2$ (Merck) and Ni powder (Cerac 325 mesh) with mole fractions TiO$_2$ : C = 1 : 3, TiO$_2$ : CaCl$_2$ = 1 : 0.25, and TiO$_2$ : Ni = 1 : 0.05. The carbon source contains 21wt% volatile components which was compensated for.

The powders were mixed in 2-propanole and allowed for mixing on a rolling bench for 24 hours and then dried and subjected to carbothermal reduction with the following process parameters:

T=1480°C
t=3 hours
Protecting atmosphere: Ar(g)
p(Ar)=1bar

The whiskers produced consisted of TiC with a lattice parameter of a=4.3172(5)Å. The whisker yield was approximately 70% by volume. The whiskers are straight and of submicron size. The whiskers have the same appearance as those prepared in connection with Example 1.

Example 3

TiO$_2$ rutile powder (Tioxide sandy rutile) was mixed with carbon powder (Degussa FW200), NaCl (Merck) and Ni powder (Cerac 325 mesh) with mole fractions TiO$_2$ : C = 1 : 2, TiO$_2$ : NaCl = 1 : 0.5, and TiO$_2$ : Ni = 1 : 0.1. The carbon source contains 21 wt% volatile components which was compensated for.

The powders were mixed in ethanol and allowed for mixing on a rolling bench for 24 hours and then dried and subjected to a carbothermal nitridation with the following process parameters:

T=1250°C
t=6 hours
Protecting atmosphere: N$_2$(g)
p(N$_2$)=1 bar

The whiskers produced consisted of TiN with a lattice parameter of a=4.2473(1)Å. The whisker yield was approximately 80% by volume. The whiskers are straight and of submicron size (see figure 3).

Example 4

TiO$_2$ rutile powder (Tioxide sandy rutile) was mixed with carbon powder (Degussa FW200), NaCl (Merck) and Ni powder (Cerac 325 mesh) with mole fractions TiO$_2$ : C = 1 : 2, TiO$_2$ : NaCl = 1 : 0.5, and TiO$_2$ : NiCl$_2$ = 1 : 0.2. The carbon source contains 21 wt% volatile components which was compensated for.

The powders were mixed in ethanol and allowed for mixing on a rolling bench for 24 hours and then dried and subjected to a carbothermal nitridation with the following process parameters:

T=1250°C
t=4 hours
Protecting atmosphere: N$_2$(g)
p(N2)=1bar

The whiskers produced consisted of TiN with a lattice parameter of a=4.2488(4)Å. The whisker yield was approximately 70% by volume.

The whiskers have the same appearance as those prepared in connection with Example 3.

**Claims**

1. A method for producing in large volumes carbide, nitride or carbonitride whiskers of titanium by intimately mixing an oxide, hydroxide and/or alkali titanium oxide compound and a carbon powder in amounts to satisfy the stoichiometric requirements of the desired whisker, at least one of the halogenide containing salts LiF, KF, NaF, LiCl, NaCl, KCl, CaCl$_2$, MgCl$_2$ in a Ti:halogenide molar ratio of 1:0.05-1:3 and a metal catalyst, in a Ti:catalyst molar ratio of 1:0.01-1:0.5, that is able to dissolve Ti plus C and/or N and heating the mixture to 1000-1800°C, for 0.5-18 hours, in a non-oxidative atmosphere containing nitrogen in case such whiskers are desired **characterised in that** said carbon powder has a primary grain size of 10-50 nm and contains a volatile part of 10-30 weight %, which part volatilises at temperatures above 500°C and **in that** the pressure of said non-oxidative atmosphere is 0.5-5 bar.

2. The method of any of the preceding claims **characterised in that** the grain size of the carbon powder is about 15 nm.

3. The method of any of the preceding claims **characterised in that** the volatile part of the carbon powder consists of oxygen-containing functional groups such as carboxyl and chinon.

4. The method of any of the preceding claims **characterised in that** said metal catalyst is Ni and/or Co.

5. The method of any of the preceding claims **characterised in that** the atmosphere contains a chlorine-containing gas.

6. The method of claim 6 **characterised in that** the chlorine-containing gas is HCl or $Cl_2$.


**Patentansprüche**

1. Verfahren zur Herstellung von Carbid-, Nitrid- oder Carbonitridwhiskern von Titan in großen Volumina durch inniges Vermischen einer Oxid-, Hydroxid- und/oder Alkalititanoxidverbindung und eines Kohlenstoffpulvers in Mengen, die den stöchiometrischen Erfordernissen der erwünschten Whisker genügen, wenigstens eines der halogenidhaltigen Salze LiF, KF, NaF, LiCl, NaCl, KCl, $CaCl_2$, $MgCl_2$, in einem Molverhältnis von Ti:Halogenid von 1:0,05-1:3 und eines Metallkatalysators in einem Molverhältnis von Ti:Katalysator von 1:0,01-1:0,5, das in der Lage ist, Ti+C und/oder N aufzulösen, und Erhitzen des Gemisches auf 1000-1800°C während 0,5-18 Stunden in einer Stickstoff enthaltenden nicht oxidierenden Atmosphäre, sofern solche Whisker erwünscht sind, **dadurch gekennzeichnet, daß** das Kohlenstoffpulver eine Primärkorngröße von 10-50 nm hat und einen flüchtigen Anteil von 10-30 Gew.-% enthält, welcher sich bei Temperaturen oberhalb 500°C verflüchtigt, und daß der Druck der nicht oxidierenden Atmosphäre 0,5-5 bar ist.

2. Verfahren nach dem vorausgehenden Anspruch, **dadurch gekennzeichnet, daß** die Korngröße des Kohlenstoffpulvers etwa 15 nm ist.

3. Verfahren nach einem der vorausgehenden Ansprüche, **dadurch gekennzeichnet, daß** der flüchtige Anteil des Kohlenstoffpulvers aus sauerstoffhaltigen funktionellen Gruppen, wie Carboxyl und Chinon, besteht.

4. Verfahren nach einem der vorausgehenden Ansprüche, **dadurch gekennzeichnet, daß** der Metallkatalysator Ni und/oder Co ist.

5. Verfahren nach einem der vorausgehenden Ansprüche, **dadurch gekennzeichnet, daß** die Atmosphäre ein chlorhaltiges Gas enthält.

6. Verfahren nach Anspruch 5, **dadurch gekennzeichnet, daß** das chlorhaltige Gas HCl oder $Cl_2$ ist.


**Revendications**

1. Procédé de fabrication à grande échelle de barbes en carbure, nitrure, carbonitrure de titane par mélange intime d'un composé d'oxyde, d'hydroxyde et/ou d'oxyde alcalin de titane et d'une poudre de carbone en de quantités permettant de satisfaire les conditions stoechiométriques de la barbe désirée, au moins l'un des halogénures étant constitué de sels tels que LiF, KF, NaF, LiCl, NaCl, KCl, $CaCl_2$, $MgCl_2$ selon un rapport molaire Ti:halogénure de 1:0,05 à 1:3 et un catalyseur métallique selon un rapport molaire Ti:catalyseur de 1:0,01 à 1:0,5, qui soit apte à dissoudre Ti plus C et/ou N et chauffage du mélange jusqu'à entre 1000 à 1800°C, pendant 0,5 à 18 heures, sous une atmosphère non oxydante contenant de l'azote dans le cas où de telles barbes sont désirées, **caractérisé en ce que** ladite poudre de carbone a une taille de grain primaire de 10 à 50 nm et contient une partie volatile de 10 à 30% en poids, laquelle partie se volatilise à des températures supérieures à 500°C et que la pression de ladite atmosphère non oxydante est de 0,5 à 5 bar.

**2.** Procédé selon la revendication 1, **caractérisé en ce que** la taille de grain de la poudre de carbone est d'environ 15 nm.

**3.** Procédé selon l'une quelconque des revendications précédentes, **caractérisé en ce que** la partie volatile de la poudre de carbone est constituée de groupes fonctionnels contenant l'oxygène tels que les groupes carboxyle et quinone.

**4.** Procédé selon l'une quelconque des revendications précédentes, **caractérisé en ce que** ledit catalyseur métallique est le Ni et/ou Co.

**5.** Procédé selon l'une quelconques des revendications précédentes, **caractérisé en ce que** l'atmosphère contient un gaz contenant du chlore.

**6.** Procédé selon la revendication 5, **caractérisé en ce que** le gaz contenant du chlore est HCl ou $Cl_2$.

Fig. 1

**Fig. 2**

**Fig. 3**